# EUROPEAN PATENT SPECIFICATION

(11) **EP 3 375 767 B1**
(45) Date of publication and mention of the grant of the patent: **13.05.2020**
(21) Application number: 17161264.1
(22) Date of filing: 16.03.2017
(51) Int. Cl.: C04B 41/91, C04B 37/02, H01L 23/373

(54) **ELECTROCHEMICALLY ROBUST CERAMIC SUBSTRATES**
ELEKTROCHEMISCH ROBUSTE KERAMIKSUBSTRATE
SUBSTRATS EN CÉRAMIQUE ÉLECTROCHIMIQUEMENT ROBUSTES

(43) Date of publication of application: 19.09.2018
(73) Proprietor: Infineon Technologies AG, 85579 Neubiberg (DE)
(72) Inventor: Roth, Alexander, 93197 Zeitlarn (DE)
(74) Representative: Dilg, Haeusler, Schindelmann Patentanwaltsgesellschaft mbH

(56) References cited:
- EP-A1- 2 199 267
- EP-A1- 2 991 099
- DE-A1- 4 138 214
- JP-A- H06 166 563
- CHEMICAL ABSTRACTS, CHEMICAL ABSTRACTS SERVICE (C A S), US, 7 October 1991 (1991-10-07), XP000318026, ISSN: 0009-2258

## Description

The invention relates to a sintered ceramic substrate, a process for treating a sintered ceramic substrate, a process for forming a sintered ceramic substrate, a direct bonded copper (DBC) substrate and power modules.

In the recent few years, high power electronic becomes one of the fastest growing market segments of semiconductor industry because of the strong demand of high energy conversion efficiency and low energy loss. Beside high operation voltages and high operation currents power devices or modules are also operated under high temperature and harsh environmental conditions such as, e.g., heat, humidity, or air pollution. Therefore, power devices or modules must achieve outstanding characteristics in terms of electrical, thermal, and mechanical performance, in order to provide reliable functionality during operation.

Power device or modules comprise ceramic substrates which serve as insulator, thermal conductor as well as mechanical platform for the module. Ceramic substrates provide front-to-back as well as front-to-front isolation between areas of different electrical potential.

EP 2 199 267 A1 discloses a high purity silicon carbide structure suitable for use in high temperature silicon wafer manufacturing comprising a silicon carbide structure having a denuded zone comprising no more than about 1 x 10 12 atoms of iron/cm³.

Ceramic materials used in high power devices or modules often comprise oxides such as beryllium oxide (BeO) or alumina (Al₂O₃) or nitrides such as aluminum nitride (AIN) due to their high thermal conductivity.

Because of the high melting point of the raw materials, the fabrication of ceramic substrates from ceramic bulk materials usually includes a heat treatment step in which a powder is converted into a dense solid. This step is called "sintering". Ceramic substrates, and in particular alumina substrates, are most commonly produced using liquid phase sintering. Liquid phase sintering involves the addition of an additive to the ceramic powder which will melt before the matrix phase. The liquid additive aids compaction of the ceramic bulk material grains. Typical additives comprise glass materials. Accordingly, a liquid phase sintered ceramic substrate consists of compacted ceramic material particles and a glassy additive phase. After sintering, the glassy additive phase is present in the pores and on the surface of the obtained "ceramic material skeleton".

Alternatively, sintering can be performed without a liquid phase at higher temperatures and pressures.

In order to enhance the performance of the sintering process and/or to control grain growth, sintering aids may be added. In particular, metal salts and/or metal oxides are used as sintering aids.

DE 41 38 214 A1 discloses a process for (pre-)treating aluminum nitride ceramics comprising an accumulation of sintering aids in the form of a glass skin on their surface. The glass skin is perforated or removed by a mechanical pretreatment and an intermediate treatment and, then, the ceramic surface is finely roughened by means of a chemical after-treatment. The sintering aids comprise Y₂0₃ or CaO.

Alumina, beryllium oxide and aluminum nitride substrates are widely used in direct bonded copper (DBC) substrates. DBC substrates are composed of a ceramic tile with a sheet of copper bonded to one or both sides.

Direct bonded copper (DBC) substrates are commonly used in power modules, because of their very good thermal conductivity. Power modules are expected to operate under rugged conditions with exposure to moisture. Under operation and under influence of moisture, electrochemical migration may occur on the ceramic substrate if compounds are present on the surface which could provide metal ions either in their raw state or after processing.

Accordingly, it is an object of the invention to improve reliability of power devices or modules comprising sintered ceramic substrates.

This object is achieved by a sintered ceramic substrate obtained from a ceramic bulk material, a sintering aid, and optionally impurities wherein the weight amount of ceramic bulk material in at least one surface of the sintered ceramic substrate is higher than in the body of the ceramic substrate, wherein the ceramic bulk material is selected from the group consisting of Al₂O₃, zirconia toughened alumina (ZTA), AIN, Si₃N₄, and mixtures thereof, and wherein the sintering aid is selected from the group consisting of FeO, Fe₂O₃, Fe₃O₄, and mixtures thereof.

In other words, the present invention yields a sintered ceramic substrate obtained from a ceramic bulk material, a sintering aid and optionally impurities wherein the weight amount of sintering aid and/or reaction product(s) thereof and/or impurities and/or reaction product(s) thereof in at least one surface of the sintered ceramic substrate is lower than in the body of the sintered ceramic substrate, wherein the ceramic bulk material is selected from the group consisting of Al₂O₃, zirconia toughened alumina (ZTA), AIN, Si₃N₄, and mixtures thereof, and wherein the sintering aid is selected from the group consisting of FeO, Fe₂O₃, Fe₃O₄, and mixtures thereof.

The sintering aids and/or reaction product(s) thereof and/or impurities and/or reaction products thereof may get mobilized on the ceramic surface during later processing/assembling steps, e.g. by contact with common reducing agents (e.g. formic acid) during soldering. During operation of the power module mobilized sintering aids and/or reaction products thereof and/or impurities and/or reaction products thereof will electrochemically migrate and, thus, cause short circuits. This is particular true when iron oxides are used as sintering aid and/or are present as impurities.

By removing at least parts of the sintering aids and/or reaction product(s) thereof and/or impurities and/or reaction products thereof from the surface of a sintered ceramic substrate these issues can be reduced or even completely avoided. Or in other words, by increasing the weight amount of ceramic bulk material in at least one surface of the sintered ceramic substrate compared to the body of the ceramic substrate the likelihood of issues caused by sintering aids and/or reaction product(s) thereof and/or impurities and/or reaction product(s) thereof can be reduced or even completely avoided.

The ceramic bulk material is selected from the group consisting of Al₂O₃, zirconia toughened alumina (ZTA), AIN and Si₃N₄, and mixtures thereof. In a preferred embodiment of the invention, the ceramic bulk material comprises Al₂O₃ or zirconia toughened alumina (ZTA).

Al₂O₃, which is an electrical insulator but has a relatively high thermal conductivity for a ceramic material is widely used as ceramic substrate because of its low cost.

Al₂O₃ is commercially available in different purity ranges. It is preferred that the purity of the alumina used to prepare the sintered ceramic substrate is of at least 96 % or of at least 99 %.

Alternatively, a zirconia toughened alumina (ZTA) can advantageously be used. Zirconia toughened alumina is a ceramic material comprising alumina and zirconia. It is a composite ceramic material with zirconia grains in the alumina matrix. It is preferred that the ZTA is based on alumina with a purity of at least 99 %. Less pure variations with reduced mechanical properties may also be used.

Sintering aids are functional additives or dopants that promote densification of the ceramic bulk material during sintering. Preferably, the amount of sintering aids in the sintered ceramic substrate is up to 4 % by weight with respect to the total weight of the sintered ceramic substrate.

The sintering aid is selected from the group consisting of FeO, Fe₂O₃, Fe₃O₄, and mixtures thereof.

It is known in the art, that sintering aids may undergo reactions with other compounds present during the sintering process or later high-temperature processes such as DBC or AMB (active metal braze) processes. For example, iron oxides may react with alumina to form an iron spinel (FeAl₂O₄).

The ceramic bulk material may comprise impurities. Such ceramic bulk material impurities may also cause issues during operation of a power module. It is preferred that the weight amount of at least one ceramic bulk material impurity and/or reaction product(s) thereof in the at least one surface of the sintered ceramic substrate is lower than in the body of the sintered ceramic substrate.

Ceramic bulk material impurities may in particular comprise metal atoms, metal oxides or metal salts. For example, impurities in Al₂O₃ or ZTA may comprise residues from armatures or equipment used in producing said ceramics, which leads to unintentional mixing of ceramic bulk material with e.g. iron oxide, or plating/surface materials, e.g. zinc or chromium or nickel and the associated oxides.

Removing at least parts of the sintering aids and/or reaction products thereof and/or impurities and/or reaction product(s) thereof from at least one of the surfaces of a sintered ceramic substrate leads to a sintered ceramic substrate in which the weight amount of ceramic bulk material in at least one surface of the sintered ceramic substrate is higher than in the body of the ceramic substrate.

Removal of at least parts of the sintering aids and/or reaction products thereof and/or impurities and/or reaction product(s) thereof from at least one of the surfaces of a sintered ceramic substrate also leads to a sintered ceramic substrate in which the weight amount of sintering aid and/or reaction product(s) thereof and/or impurities and/or reaction product(s) thereof in the at least one surface of the sintered ceramic substrate is lower than in the body of the sintered ceramic substrate.

Removal of sintering aids and/or reaction products thereof from a surface of a sintered ceramic substrate can be achieved by chemical and/or mechanical means.

Removal of ceramic bulk material impurities and/or reaction product(s) thereof from a surface of a sintered ceramic substrate can be achieved by the same chemical and/or mechanical means.

In particular, removal of sintering aids and/or reaction products thereof and/or impurities and/or reaction products thereof from a surface of a sintered ceramic substrate can be achieved by first treating the surface of the sintered ceramic substrate with a reducing agent, preferably selected from the group consisting of H₂, formic acid, forming gas, and mixtures thereof. Preferably, the reducing agents are contacted with the liquid phase sintered ceramic body at a temperature of 300 °C or higher. With the help of a reducing agent, metal cations such as Fe²⁺ and/or Fe³⁺ are reduced to the elemental metal, such as elemental iron.

By subsequently treating the surface of the sintered ceramic substrate with an aqueous etching solution comprising an acid, I₂/KI or mixtures thereof the elemental metal, such as elemental iron, is removed.

This stepwise removal of the sintering aid and/or reaction product(s) thereof and/or impurities and/or reaction product(s) thereof needs not to be done directly after the sintering process but can be done during later processing of the sintered ceramic body, e.g. during metallization or assembly.

A sintered ceramic substrate comprises a body and at least one surface. If the body has a cubic, a cuboid or other polyhedral shape, the number of surfaces is higher.

According to the present invention, the weight amount of ceramic bulk material in at least one surface of the sintered ceramic substrate is higher than in the body of the ceramic substrate. In different embodiments of the invention, the weight amount of ceramic bulk material in at least two or more surfaces of the sintered ceramic substrate is higher than in the body of the ceramic substrate.

It may be preferred, that the weight amount of sintering aid and/or reaction product(s) thereof and/or impurities and/or reaction product(s) thereof in at least one surface of the sintered ceramic substrate is lower than in the body of the ceramic substrate. In other preferred embodiments of the invention, the weight amount of sintering aid and/or reaction product(s) thereof and/or impurities and/or reaction product(s) thereof in at least two or more surfaces of the sintered ceramic substrate is lower than in the body of the ceramic substrate.

In geometry, a surface is the boundary of a three-dimensional geometric body. Within the scope of this invention a surface of a sintered ceramic substrate is a layer of a nanometer (monolayer) to several micrometers in thickness that is a boundary of the sintered ceramic substrate. It is preferred that the at least one surface of the ceramic substrate has a thickness that corresponds to the maximum roughness depth Rₘₐₓ of the sintered ceramic substrate. For example, Rₘₐₓ can be determined according to DIN EN ISO 4287:2010.

It is preferred that the amount of iron atoms and/or iron cations in the at least one surface of the sintered ceramic substrate is less than 200 ppmw and more preferred less than 5 ppmw.

It may be also preferred that the weight amount of iron atoms and/or iron cations in the at least one surface of the sintered ceramic substrate is 5 %, and more preferred 50 %, lower than in the body of the sintered ceramic substrate.

The weight amounts of sintering aid(s) and/or reaction product(s) thereof and/or ceramic bulk material impurities and/or reaction product(s) thereof, in particular of iron atoms and/or iron cations, in the at least one surface of the sintered ceramic substrate can, for example, be determined by Auger electron spectroscopy (AES) or Time-of-Flight secondary-ion mass spectrometry (ToF-SIMS) on a cross-section of the sintered ceramic substrate.

It may be preferred that the at least one surface of the ceramic substrate comprises a weight gradient in which the weight proportion of ceramic bulk material in the sintered ceramic substrate increases in a direction away from the center of the body of the sintered ceramic substrate.

It may also be preferred that the at least one surface of the ceramic substrate comprises a weight gradient in which the weight proportion of sintering aid and/or reaction product(s) thereof decreases in a direction away from the center of the body of the ceramic substrate. If present, it may be preferred that the weight proportion of at least one ceramic bulk material impurity and/or reaction product thereof in the sintered ceramic substrate comprises a weight gradient in which the weight proportion of at least one ceramic bulk material impurity and/or reaction product(s) thereof decreases in a direction away from the center of the body of the ceramic substrate.

Ceramic substrates, and in particular alumina substrates, are commonly produced using liquid phase sintering. A liquid phase sintered ceramic substrate is usually obtained from a ceramic material, a glass additive and a sintering aid. Impurities, in particular ceramic bulk material impurities, may also be present.

If present, sintering aids, ceramic bulk material impurities and reaction products thereof concentrate in the glass phase formed during the liquid phase sintering process since the ceramic bulk material remains solid at the sintering temperatures.

In different embodiments of the invention the glass phase formed on the at least one surface of the obtained "ceramic material skeleton" is completely removed. After complete removal of the glass phase from the at least one surface, the predominant amount of the remaining sintering aid and/or reaction products thereof and/or ceramic bulk material impurities and/or reaction products thereof is within the body of the sintered ceramic substrate, namely in pores of the obtained "ceramic material skeleton". Consequently, the weight amount of sintering aid and/or reaction product(s) thereof and/or ceramic bulk material impurities and/or reaction products thereof in the surface is lower than in the body of the sintered ceramic substrate. In addition, after complete removal of the glass phase from the at least one surface the weight amount of ceramic bulk material in the at least one surface of the sintered ceramic substrate is higher than in the body of the ceramic substrate.

Removal of the glass phase from the at least one surface can be done by chemical and/or mechanical means.

Mechanical means for removing the glass phase from the surface of a liquid phase sintered ceramic substrate comprise lapping or abrasive blasting, in particular sandblasting.

Since ceramic materials are very resistant to chemical attack, the glass phase formed on the surface of the "ceramic material skeleton" of a liquid phase sintered ceramic substrate can be removed by the use of etchants. For example, strong acids like HF, HNO₃, HCI or similar can be used to remove the glass phase. In particular, strong acids are used as etchants to remove the glass phase on the surface of the "ceramic material skeleton" of a liquid phase sintered ceramic substrate comprising Al₂O₃. For non-alumina ceramics such as AIN strong acids or alkaline etchants such as NaOH can be used to remove the glass phase. Chemical removal of the glass phase using an alkaline etchant is facilitated if the process is carried out at temperature of 80 °C or higher.

In alternative embodiments of the invention only parts of the glass phase are removed. In particular, sintering aids and/or reaction products thereof and/or ceramic bulk material impurities and/or reaction products thereof are removed from the glass phase with the help of the above described two-step-process comprising a reduction step with a reducing agent comprising H₂, formic acid and/or forming gas and an etching step using an aqueous etching solution comprising an acid, I₂/KI or mixtures thereof. In these embodiments, the glass phase forms the surface of the sintered ceramic substrate and the "ceramic material skeleton" is the body.

A further aspect of the present invention is a process for treating a sintered ceramic substrate obtained from a ceramic bulk material, a sintering aid, and optionally impurities comprising:
a) treating at least one surface of the sintered ceramic substrate with a reducing agent, preferably selected from the group consisting of H₂, formic acid, forming gas, and mixtures thereof, and
b) treating the at least one surface with an aqueous etching solution, preferably comprising an acid, such as HCl or HNO₃, I₂/KI, and mixtures thereof,
wherein the ceramic bulk material is selected from the group consisting of Al₂O₃, zirconia toughened alumina (ZTA), AIN, Si₃N₄, and mixtures thereof, and wherein the sintering aid is selected from the group consisting of FeO, Fe₂O₃, Fe₃O₄, and mixtures thereof.

Yet a further aspect of the present invention is a process for forming a sintered ceramic substrate comprising: sintering a ceramic bulk material, a glass additive, a sintering aid and optionally impurities; and
chemically and/or mechanically removing at least parts of a glass phase formed on the surface(s) of the obtained sintered ceramic substrate during sintering from at least one surface,
wherein the ceramic bulk material is selected from the group consisting of Al₂O₃, zirconia toughened alumina (ZTA), AlN, Si₃N₄, and mixtures thereof, and wherein the sintering aid is selected from the group consisting of FeO, Fe₂O₃, Fe₃O₄, and mixtures thereof.

Since a sintered ceramic substrate of the present invention or obtained from a process according to the present invention exhibits improved electrochemical robustness, it can advantageously be used in (high) power modules. Accordingly, yet a further aspect of the present invention is a power module comprising a sintered ceramic substrate according of the present invention or obtained from a process according to the invention.

Still a further object of the invention is directed to a direct bonded (DBC) substrate comprising:
a sintered ceramic substrate according to the present invention or obtained from a process according to the present invention;
a first, optionally patterned, copper layer connected to a first surface of the sintered ceramic substrate; and
a second, optionally patterned, copper layer connected to a second surface of the sintered ceramic substrate.

With the help of a direct bonded (DBC) substrate according to the present invention power modules without the need for hermetic packaging can be manufactured. Accordingly, a further aspect of the present invention is a power module comprising a direct bonded (DBC) substrate according to the present invention.

With respect to further preferred embodiments of the sintered ceramic substrate, the power module comprising a sintered ceramic substrate, the direct bonded (DBC) substrate and the power module comprising the direct bonded (DBC) substrate apply mutatis mutandis to the inventive process for forming a sintered ceramic substrate said.

## Claims

1. A sintered ceramic substrate obtained from a ceramic bulk material, a sintering aid, and optionally impurities, **characterized in that** the weight amount of ceramic bulk material in at least one surface of the sintered ceramic substrate is higher than in the body of the ceramic substrate, wherein the ceramic bulk material is selected from the group consisting of Al₂O₃, zirconia toughened alumina (ZTA), AlN, Si₃N₄, and mixtures thereof, and
wherein the sintering aid is selected from the group consisting of FeO, Fe₂O₃, Fe₃O₄, and mixtures thereof.

2. The sintered ceramic substrate according to claim 1,
wherein the at least one surface of the sintered ceramic substrate was treated with an acidic etchant or an alkaline etchant after sintering.

3. The sintered ceramic substrate according to claim 1,
wherein the at least one surface of the sintered ceramic substrate was treated by abrasive blasting or lapping after sintering.

4. The sintered ceramic substrate according to claim 1,
wherein the at least one surface of the sintered ceramic substrate was initially treated with a reducing agent selected from the group consisting of H₂, formic acid, forming gas, and mixtures thereof, and was subsequently treated with an aqueous etching solution comprising an acid, such as HCI or HNO₃, I₂/KI, and mixtures thereof after sintering.

5. The sintered ceramic substrate according to any of the claims 1 to 4,
wherein the sintered ceramic substrate was obtained by liquid phase sintering.

6. A process for treating a sintered ceramic substrate obtained from a ceramic bulk material, a sintering aid, and optionally impurities comprising:
a) treating at least one surface of a sintered ceramic substrate with a reducing agent, preferably selected from the group consisting of H₂, formic acid, forming gas, and mixtures thereof, and
b) treating the at least one surface with an aqueous etching solution, preferably comprising an acid, such as HCI or HNO₃, I₂/KI, and mixtures thereof,
wherein the ceramic bulk material is selected from the group consisting of Al₂O₃, zirconia toughened alumina (ZTA), AlN, Si₃N₄, and mixtures thereof, and
wherein the sintering aid is selected from the group consisting of FeO, Fe₂O₃, Fe₃O₄, and mixtures thereof.

7. A process for forming a sintered ceramic substrate comprising:
sintering a ceramic bulk material, a glass additive and a sintering aid; and chemically and/or mechanically removing at least parts of a glass phase formed on the surface(s) of the obtained sintered ceramic substrate during sintering from at least one surface,
wherein the ceramic bulk material is selected from the group consisting of Al₂O₃, zirconia toughened alumina (ZTA), AlN, Si₃N₄, and mixtures thereof, and
wherein the sintering aid is selected from the group consisting of FeO, Fe₂O₃, Fe₃O₄, and mixtures thereof.

8. The process for forming a sintered ceramic substrate according to claim 7, wherein the ceramic bulk material comprises impurities.

9. A power module comprising a sintered ceramic substrate according to any of the claims 1 to 5 or obtained by a process according to any of the claims 6 to 8.

10. A direct bonded (DBC) substrate comprising:
a sintered ceramic substrate according to any of the claims 1 to 5 or obtained by a process according to any of the claims 6 to 8;
a first, optionally patterned, copper layer connected to a first surface of the sintered ceramic substrate; and
a second, optionally patterned, copper layer connected to a second surface of the sintered ceramic substrate.

11. A power module comprising a direct bonded (DBC) substrate according to claim 10.

## Patentansprüche

1. Ein gesintertes Keramiksubstrat, das aus einem Keramikgrundmaterial, einem Sinterhilfsmittel und optional Verunreinigungen erhalten wurde, **dadurch gekennzeichnet, dass** die Gewichtsmenge an Keramikgrundmaterial in mindestens einer Oberfläche des gesinterten Keramiksubstrats höher ist als im Körper des Keramiksubstrats, wobei das Keramikgrundmaterial aus der Gruppe, bestehend aus Al₂O₃, mit Zirkoniumdioxid verstärktes Aluminiumoxid (ZTA), AlN, Si₃N₄ und Mischungen davon, ausgewählt ist und
wobei das Sinterhilfsmittel aus der Gruppe, bestehend aus FeO, Fe₂O₃, Fe₃O₄ und Mischungen davon, ausgewählt ist.

2. Das gesinterte Keramiksubstrat gemäß Anspruch 1,
wobei die mindestens eine Oberfläche des gesinterten Keramiksubstrats mit einem sauren Ätzmittel oder einem alkalischen Ätzmittel nach dem Sintern behandelt wurde.

3. Das gesinterte Keramiksubstrat gemäß Anspruch 1,
wobei die mindestens eine Oberfläche des gesinterten Keramiksubstrats durch Strahlen oder Läppen nach dem Sintern behandelt wurde.

4. Das gesinterte Keramiksubstrat gemäß Anspruch 1,
wobei die mindestens eine Oberfläche des gesinterten Keramiksubstrats zunächst mit einem Reduktionsmittel, das aus der Gruppe, bestehend aus H₂, Ameisensäure, Formiergas und Mischungen davon, ausgewählt ist, behandelt wurde und anschließend mit einer wässrigen Ätzlösung, die eine Säure, wie zum Beispiel HCl oder HNO₃, I₂/KI und Mischungen davon umfasst, nach dem Sintern behandelt wurde.

5. Das gesinterte Keramiksubstrat gemäß einem der Ansprüche 1 bis 4,
wobei das gesinterte Keramiksubstrat durch Flüssigphasensintern erhalten wurde.

6. Ein Verfahren zum Behandeln eines gesinterten Keramiksubstrats, das aus einem Keramikgrundmaterial, einem Sinterhilfsmittel und optional Verunreinigungen erhalten wurde, wobei das Verfahren Folgendes umfasst:
a) Behandeln mindestens einer Oberfläche eines gesinterten Keramiksubstrats mit einem Reduktionsmittel, das aus der Gruppe, bestehend aus H₂, Ameisensäure, Formiergas und Mischungen davon, ausgewählt ist, und
b) Behandeln der mindestens einen Oberfläche mit einer wässrigen Ätzlösung, die vorzugsweise eine Säure, wie zum Beispiel HCl oder HNO₃, I₂/KI und Mischungen davon umfasst,
wobei das Keramikgrundmaterial aus der Gruppe, bestehend aus Al₂O₃, mit Zirkoniumdioxid verstärktes Aluminiumoxid (ZTA), AlN, Si₃N₄ und Mischungen davon, ausgewählt ist und
wobei das Sinterhilfsmittel aus der Gruppe, bestehend aus FeO, Fe₂O₃, Fe₃O₄ und Mischungen davon, ausgewählt ist.

7. Ein Verfahren zum Bilden eines gesinterten Keramiksubstrats, wobei das Verfahren Folgendes umfasst:
Sintern eines Keramikgrundmaterials, eines Glasadditivs und eines Sinterhilfsmittels; und
chemisches und/oder mechanisches Entfernen von zumindest Teilen einer Glasphase, die auf der Oberfläche bzw. den Oberflächen des erhaltenen gesinterten Keramiksubstrat während des Sinterns gebildet wurden, von mindestens einer Oberfläche,
wobei das Keramikgrundmaterial aus der Gruppe, bestehend aus Al₂O₃, mit Zirkoniumdioxid verstärktes Aluminiumoxid (ZTA), AlN, Si₃N₄ und Mischungen davon, ausgewählt ist und
wobei das Sinterhilfsmittel aus der Gruppe, bestehend aus FeO, Fe₂O₃, Fe₃O₄ und Mischungen davon, ausgewählt ist.

8. Das Verfahren zum Bilden eines gesinterten Keramiksubstrats gemäß Anspruch 7, wobei das Keramikgrundmaterial Verunreinigungen umfasst.

9. Ein Leistungsmodul, das ein gesintertes Keramiksubstrat nach einem der Ansprüche 1 bis 5 oder erhalten durch ein Verfahren nach einem der Ansprüche 6 bis 8 umfasst.

10. Ein Direct bonded (DBC) Substrat, umfassend:
ein gesintertes Keramiksubstrat nach einem der Ansprüche 1 bis 5 oder erhalten durch ein Verfahren nach einem der Ansprüche 6 bis 8;
eine erste, optional mit einem Muster versehene bzw. strukturierte, Kupferlage, die mit einer ersten Oberfläche des gesinterten Keramiksubstrats verbunden ist; und
eine zweite, optional mit einem Muster versehene bzw. strukturierte, Kupferlage, die mit einer zweiten Oberfläche des gesinterten Keramiksubstrats verbunden ist.

11. Ein Leistungsmodul, das ein Direct bonded (DBC) Substrat nach Anspruch 10 umfasst.

## Revendications

1. Substrat en céramique frittée obtenu à partir d'un matériau céramique en vrac, d'un adjuvant de frittage et éventuellement d'impuretés, **caractérisé en ce que** la quantité en poids de matériau céramique en vrac dans au moins une surface du substrat en céramique frittée est plus élevée que dans le corps du substrat en céramique, dans lequel le matériau céramique en vrac est choisi dans le groupe constitué par Al₂O₃, l'alumine renforcée par de la zircone (ZTA), AlN, Si₃N₄ et des mélanges de ceux-ci, et
dans lequel l'adjuvant de frittage est choisi dans le groupe constitué par FeO, Fe₂O₃, Fe₃O₄ et des mélanges de ceux-ci.

2. Substrat en céramique frittée selon la revendication 1,
dans lequel au moins une surface du substrat en céramique frittée a été traitée avec un agent d'attaque chimique acide ou un agent d'attaque chimique alcalin après frittage.

3. Substrat en céramique frittée selon la revendication 1,
dans lequel au moins une surface du substrat en céramique frittée a été traitée par projection d'abrasif ou rodage après frittage.

4. Substrat en céramique frittée selon la revendication 1,
dans lequel au moins une surface du substrat en céramique frittée a été initialement traitée avec un agent réducteur choisi dans le groupe constitué par H₂, l'acide formique, du mélange hydrogène-azote et des mélanges de ceux-ci, et a par la suite été traitée avec une solution aqueuse d'attaque chimique comprenant un acide, tel que HCl ou HNO₃, I₂/KI et des mélanges de ceux-ci après frittage.

5. Substrat en céramique frittée selon l'une quelconque des revendications 1 à 4,
dans lequel le substrat en céramique frittée a été obtenu par frittage avec phase liquide.

6. Procédé de traitement d'un substrat en céramique frittée obtenu à partir d'un matériau céramique en vrac, d'un adjuvant de frittage et éventuellement d'impuretés comprenant :
a) le traitement d'au moins une surface d'un substrat en céramique frittée avec un agent réducteur, de préférence choisi dans le groupe constitué par H₂, l'acide formique, du mélange hydrogène-azote et des mélanges de ceux-ci, et
b) le traitement d'au moins une surface avec une solution aqueuse d'attaque chimique, de préférence comprenant un acide, tel que HCl ou HNO₃, I₂/KI et des mélanges de ceux-ci,
dans lequel le matériau céramique en vrac est choisi dans le groupe constitué par Al₂O₃, l'alumine renforcée par de la zircone (ZTA), AlN, Si₃N₄ et des mélanges de ceux-ci et
dans lequel l'adjuvant de frittage est choisi dans le groupe constitué par FeO, Fe₂O₃, Fe₃O₄ et des mélanges de ceux-ci.

7. Procédé de formation d'un substrat en céramique frittée comprenant :
le frittage d'un matériau céramique en vrac, d'un additif vitreux et d'un adjuvant de frittage ; et
l'élimination, d'au moins une surface, de manière chimique et/ou de manière mécanique, au moins de parties d'une phase vitreuse formée pendant le frittage sur la ou les surfaces du substrat en céramique frittée obtenu,
dans lequel le matériau céramique en vrac est choisi dans le groupe constitué par Al₂O₃, l'alumine renforcée par de la zircone (ZTA), AlN, Si₃N₄ et des mélanges de ceux-ci et
dans lequel l'adjuvant de frittage est choisi dans le groupe constitué par FeO, Fe₂O₃, Fe₃O₄ et des mélanges de ceux-ci.

8. Procédé de formation d'un substrat en céramique frittée selon la revendication 7, dans lequel le matériau céramique en vrac comprend des impuretés.

9. Module d'alimentation comprenant un substrat en céramique frittée selon l'une quelconque des revendications 1 à 5 ou obtenu par un procédé selon l'une quelconque des revendications 6 à 8.

10. Substrat directement lié (DBC) comprenant :
un substrat en céramique frittée selon l'une quelconque des revendications 1 à 5 ou obtenu par un procédé selon l'une quelconque des revendications 6 à 8 ;
une première couche de cuivre, éventuellement à motifs, reliée à une première surface du substrat en céramique frittée ; et
une seconde couche de cuivre, éventuellement à motifs, reliée à une seconde surface du substrat en céramique frittée.

11. Module d'alimentation comprenant un substrat directement lié (DBC) selon la revendication 10.
